# EUROPEAN PATENT APPLICATION

(11) **EP 4 625 414 A1**
(43) Date of publication of application: **01.10.2025**
(21) Application number: 24166692.4
(22) Date of filing: 27.03.2024
(51) Int. Cl.: G11C 11/22

(54) **A MEMORY DEVICE AND METHOD FOR NON-DESTRUCTIVE READ-OUT OF A FERROELECTRIC MEMORY CELL**

(71) Applicant: IMEC vzw, 3001 Leuven (BE)
(72) Inventor: Hiblot, Gaspard, deceased (BE); Van Houdt, Jan, 3460 Bekkevoort (BE); Van der Plas, Geert, 3000 Leuven (BE); Gupta, Mohit, 3001 Heverlee (BE)
(74) Representative: Roth, Sebastian

(57) **Abstract**

The present disclosure relates to a memory device, which includes a ferroelectric memory cell and a readout circuit connected to the memory cell. The disclosure also relates to a method for non-destructively reading out the ferroelectric memory cell of the memory device. The memory device comprises a memory cell having a ferroelectric capacitor. A word line and a bit line are respectively connected to the memory cell. The memory device further comprises a reference cell having a ferroelectric capacitor. A reference word line and a reference bit line are respectively connected to the reference cell. A set of first switches is configured to connect the bit line and the reference bit line to a reference voltage, and a set of second switches is configured to connect the bit line and the reference bit line to a summing node of a readout circuit. The readout circuit further comprises a differential amplifier configured to receive a summing result of the summing node and the reference voltage as two input, a comparator configured to receive an output of the differential amplifier and the reference voltage as two inputs, and an accumulation capacitor connected in parallel to the differential amplifier between the summing node and the comparator.

## Description

### TECHNICAL FIELD

The present disclosure relates to the field of capacitor-based ferroelectric memory devices. In particular, the present disclosure relates to a memory device, which includes a ferroelectric memory cell and a readout circuit connected to the memory cell. The disclosure also relates to a method for non-destructively reading out the ferroelectric memory cell of the memory device.

### BACKGROUND

A ferroelectric memory cell stores data in a non-volatile manner using different polarization states (e.g. "up", "down") of a ferroelectric material. A memory device typically comprises an array of such memory cells, wherein each memory cell comprises a ferroelectric capacitor and a select transistor (so-called 1T-1C memory configuration). The ferroelectric material is arranged between the two capacitor plates of the ferroelectric capacitor, and the polarization state of the ferroelectric material defines the memory state of the memory cell.

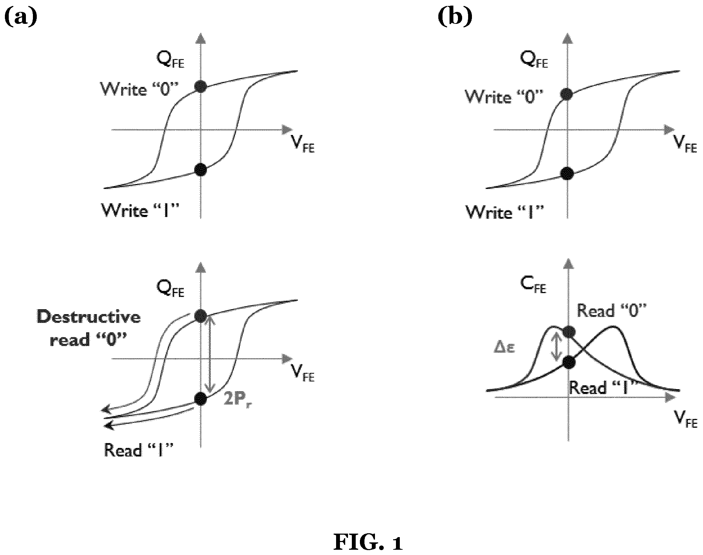

To read out the memory state, the memory cell may be forced to a known memory state, i.e., to a particular net polarization state of the ferroelectric material. Based on the response of the memory cell, it can then be deduced whether the memory state has changed as a result or not. In 50% of the cases (on average) the current memory state of the memory cell is overwritten during such a read-out, and the memory cell needs to be reprogrammed afterwards. This read-out scheme is thus a so-called destructive read-out, and is illustrated in FIG. 1(a). The lower diagram in FIG. 1(a) illustrates the destructive read-out, and the upper diagram illustrates the write.

In case of the destructive read-out scheme, the endurance of the memory cell, i.e., the total number of attainable write/erase cycles, is limited and linked to the number of read cycles. In addition, since the read-out scheme requires a voltage that is sufficiently high to switch the memory cell to a known memory state, and since the memory cells also need to be rewritten in 50% of the cases, the power consumption of the memory device is high.

Moreover, the select transistors, which are used for decoding of the memory cells of the memory device in the 1T-1C configuration, enhance the size of the memory cells, and make the memory cells more or less un-stackable, especially when using silicon transistors.

Overall, an improved memory device and a new scheme for reading-out ferroelectric memory cells is thus desired.

### SUMMARY

The present disclosure and its solutions are further based on the following considerations.

In an alternative read-out scheme, the memory cells are read out in a non-destructive manner. To this end, for example, different work function metals can be used for building the capacitor plates of the ferroelectric capacitor. This causes an asymmetry of a hysteresis loop of the ferroelectric material of the ferroelectric capacitor, and particularly also an asymmetry of the capacitance-voltage hysteresis. Due to this asymmetry, a capacitance and therefore also a dielectric response of the ferroelectric capacitor differs depending on the current polarization state of the ferroelectric material, even if no bias voltage is applied to the ferroelectric capacitor. This difference in capacitance (or dielectric response) is referred to as a memory window. Using this memory window, the current polarization state of the ferroelectric material can be detected by measuring a dielectric response (e.g., an effective permittivity or capacitance) of the ferroelectric material, even if no (or only a small) bias voltage is applied. Hence, the memory state of the memory cell can be read-out without having to "switch" the polarization state of the ferroelectric material of the memory cell. This read-out scheme is thus a so-called non-destructive read-out, and is illustrated in FIG. 1(b). The lower diagram in FIG. 1(b) illustrates the non-destructive read-out, and the upper diagram illustrates the write.

The non-destructive read-out scheme can be exploited, for example, to build a 0T-1C memory array, wherein the memory cells do not have a select transistor each, but comprise only the ferroelectric capacitor. A memory device based on a ferroelectric selector-less array and a non-destructive read-out scheme would offer many advantages. For example, a reliability of the memory device could be improved, because the need for a re-write after a read of a memory cell can be eliminated. Further, without select transistor per memory cell, a higher memory density and facilitated 3D stacking of memory cells can be achieved.

However, when using the non-destructive read-out scheme for a memory cell with the 0T-1C configuration, a very small signal has to be detected. This is because the difference between the two capacitance states of the ferroelectric capacitor is small, and also because a read voltage applied to the ferroelectric capacitor is small. The 0T-1C configuration poses moreover a risk of sneak current paths, due to the lack of the select transistors.

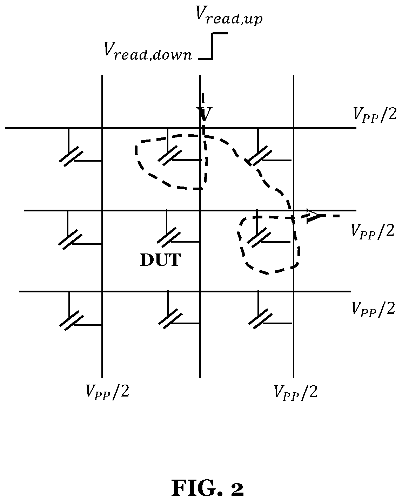

This is illustrated in FIG. 2, which shows a memory array comprising a cross-bar arrangement of word lines (vertical) and bit lines (horizontal), wherein the ferroelectric capacitor of each memory cell is connected at an intersection of one word line and one bit line to the word line with one capacitor plate and to the bit line with the other capacitor plate. The memory cell, which is denoted DUT in FIG. 2, is the memory cell to be read. Unfortunately, sneak currents through other memory cells may flow, if no counter-measures are taken to avoid them.

An objective of this disclosure is to solve the above-mentioned issues. That is, an objective is to provide a memory device including ferroelectric memory cells, which can be read out reliably using non-destructive read, while avoiding sneak paths. An objective is to provide an improved read-out scheme to ensure the reliability of the non-destructive read.

These and other objectives are achieved by the solutions of this disclosure described in the independent claims. Advantageous implementations are described in the dependent claims.

A first aspect of this disclosure provides a memory device comprising: a memory cell comprising a ferroelectric capacitor; a word line and a bit line, which are respectively connected to the memory cell; a reference cell comprising a ferroelectric capacitor; a reference word line and a reference bit line respectively connected to the reference cell; a set of first switches configured to connect, when the first switches are closed, the bit line and the reference bit line to a reference voltage; a set of second switches configured to connect, when the second switches are closed, the bit line and the reference bit line to a summing node of a readout circuit of the memory device; wherein the readout circuit comprises: the summing node; a differential amplifier configured to receive a summing result of the summing node and the reference voltage as two inputs; a comparator configured to receive an output of the differential amplifier and the reference voltage as two inputs; and an accumulation capacitor connected in parallel to the differential amplifier between the summing node and the comparator.

In the memory device of the first aspect, the bit line connected to the memory cell to be read may be biased to the same reference voltage than other bit lines of the memory device, so that sneak currents do not flow towards the bit line being read, i.e., sneak paths can be avoided. In other words, a charge transfer mechanism may be used, which keeps the bit line voltage constant, hence suppressing the sneak currents. Further in the memory device of the first aspect, by using the reference cell and the switches to read a differential signal, the problem of the small relative difference between the two capacitance states of the memory cell is addressed. The differential signal may even be integrated over several cycles, so as to further mitigate the small signal problem.

In an implementation, the memory device further comprises: a first pull-up transistor and a first pull-down transistor connected to the word line and respectively configured to pull the word line to a first read voltage and a second read voltage, wherein the first read voltage is higher than the second read voltage and the reference voltage is between the first and the second read voltage; a second pull-up transistor and a second pull-down transistor connected to the reference word line and respectively configured to pull the reference word line to the first read voltage and the second read voltage.

Control signals for controlling the pull-up and pull-down transistors, respectively, can be switched during the reading of the memory cell, along with switching the first and second set of switches, in order to enable the differential read-out.

In an implementation of the memory device, the word line is connected to a first capacitor plate of the ferroelectric capacitor of the memory cell, and the bit line is connected to a second capacitor plate of the ferroelectric capacitor of the memory cell.

This means that the memory cells of the memory device may be designed according to the 0T-1C configuration, and can consequently enjoy the above-described advantages thereof.

In an implementation of the memory device, the reference word line is connected to a first capacitor plate of the ferroelectric capacitor of the reference cell, and the reference bit line is connected to a second capacitor plate of the ferroelectric capacitor of the reference cell.

Thus, also the reference cell may use a 0T-1C configuration.

In an implementation of the memory device, the set of first switches comprises: a first switch arranged on the bit line between the ferroelectric capacitor of the memory cell and the summing node; and another first switch arranged on the reference bit line between the ferroelectric capacitor of the reference cell and the summing node.

In an implementation of the memory device, the set of second switches comprises: a second switch arranged on the bit line between the ferroelectric capacitor of the memory cell and a reference voltage node; and another second switch arranged on the reference bit line between the ferroelectric capacitor of the reference cell and the reference voltage node.

In an implementation of the memory device, the differential amplifier is configured to receive the summing result of the summing node as a non-inverting input and to receive the reference voltage as an inverting input.

In an implementation, the memory device, comprises: a plurality of memory cells including the memory cell, wherein each of the memory cells comprises a ferroelectric capacitor, and wherein the memory cells are arranged in an array comprising rows and columns; a plurality of word lines and a plurality of bit lines, wherein each of the word lines is connected to the memory cells of one row, each of the bit lines is connected to the memory cells of one column, and each of the memory cells is placed between one of the word lines and one of the bit lines; a plurality of reference cells, wherein each of the reference cells comprises a ferroelectric capacitor; one or more reference word lines and a plurality of reference bit lines, wherein each reference cell is placed between one reference word line and one of the reference bit lines; and a plurality of readout circuits, wherein each of the readout circuits comprises a summing node, a differential amplifier, a comparator and an accumulation capacitor, and wherein each of the readout circuits is associated with one pair of one of the bit lines and one of the reference bit lines.

The plurality of memory cells include the memory cell mentioned before, the plurality of word lines includes the word line connected to said memory cell, and the plurality of bit lines include the bit line connected to said memory cell. In the memory array of the memory device of the first aspect, each memory cell may be individually read out using the non-destructive differential read-out scheme.

In an implementation of the memory device, all the reference cells are arranged in an extra row of the array, and the memory device comprises one reference word line connected to all the reference cells in the extra row.

This implementation allows keeping the number of additional reference cells - and thus also the additionally occupied space in the memory array - small.

In an implementation, the memory device further comprises a memory controller, which is configured to operate the memory device according to the method of the second aspect described below.

In particular, the memory controller can implement the non-destructive differential read-out scheme proposed in this disclosure.

A second aspect of this disclosure provides a method of operating a memory device according to the first aspect or any implementation form thereof, to read out the memory cell using the reference cell, wherein the method comprises: switching the first switches and the second switches, which are associated with the bit line and the reference bit line respectively connected to the memory cell and the reference cell, in consecutive time intervals; wherein in a first time interval, the first switches are closed to connect the bit line and the reference bit line to the reference voltage, and the second switches are open; in a second time interval, the first switches are open, and the second switches are closed to connect the bit line and the reference bit line to the summing node; during the first time interval, the word line is switched from the first read voltage to the second read voltage, and the reference word line is switched from the second read voltage to the first read voltage; and during the second time interval, the word line is switched from the second read voltage to the first read voltage, and the reference word line is switched from the first read voltage to the second read voltage.

Due to the alternating switching phases of the first switches and the second switches, a charge is first sampled based on a voltage difference between the first and second read voltage on the ferroelectric capacitors of the memory cell and the reference cell during the first time interval, and is then transferred to the accumulation capacitor during the second time interval.

In an implementation, the method further comprises: switching control signals of respectively the first pull-up transistor, the first pull-down transistor, the second pull-up transistor, and the second pull-down transistor, in the consecutive time intervals, in order to respectively switch the word line and the reference word line between the first and the second read voltage.

In an implementation of the method, the control signals of the first pull-up transistor and the first pull-down transistor are switched opposite in phase compared to the control signals of respectively the second pull-up transistor and the second pull-down transistor.

In an implementation of the method, the switching of the first switches and second switches and the switching of the control signals of the first and second pull-up and pull-down transistors are non-overlapping.

The control signal pulses controlling the word line and the reference word line via the respective pull-up-and pull down transistors may have opposite polarity during the first and the second time interval, so that one bit line charges the accumulation capacitor by a charge from the reference cell, while the other one discharges it by a charge from the memory cell, hence creating a different signal at the output of the differential amplifier.

In an implementation, the method comprises multiple cycles to read out the memory cell using the reference cell, wherein each cycle comprises the first and the second time interval.

This may be done to sum up more charge at the accumulation capacitor over multiple cycles, and thus enhance the read signal. Signal amplification due to performing the read-out over several cycles is achieved.

The method of the second aspect achieves the same advantages as the device of the first aspect and maybe extended by respective implementations as described above for the device of the first aspect.

As described above, the reference word line and the word line are pulsed in opposite directions, so that the current charging the ferroelectric capacitor of the reference cell and the current charging the ferroelectric capacitor of the memory cell are also in opposite directions. The charges related to these two currents are summed up on the accumulation capacitor, hence creating a differential output voltage.

The bit line, which is sensed, is connected to a virtual bias (reference voltage), so that it does not suffer from the sneak paths, since it remains at the same potential as the neighboring word lines and/or bit lines. The operation may be repeated several times, so that the output integrate the differential charge, hence amplifying the read-out signal.

### BRIEF DESCRIPTION OF THE DRAWINGS

The above described aspects and implementations are explained in the following description of embodiments with respect to the enclosed drawings:
- FIG. 1: shows a comparison between (a) a destructive read-out scheme, and (b) a non-destructive read-out scheme.
- FIG. 2: shows a memory array in a 0T-1C configuration, and indicates sneak currents in the memory array.
- FIG. 3: illustrates the principles of the read-out scheme proposed by this disclosure.
- FIG. 4: shows a ferroelectric memory device according to this disclosure.
- FIG. 5: shows a flow-diagram of a method for operating the memory device of FIG. 4.
- FIG. 6: shows timing diagrams of signals for controlling the switches and the pull-up and pull-down transistors of the memory device of FIG. 4.
- FIG. 7: shows a memory array of a ferroelectric memory device according to this disclosure.

### DETAILED DESCRIPTION OF EMBODIMENTS

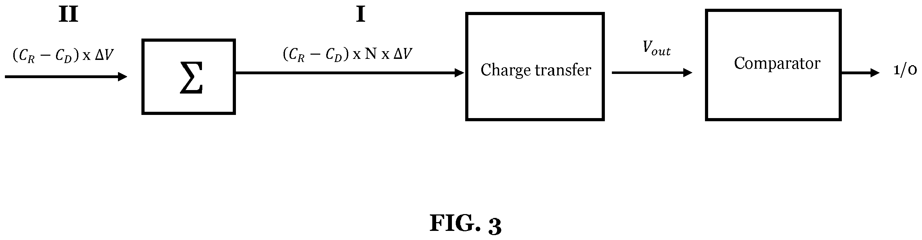

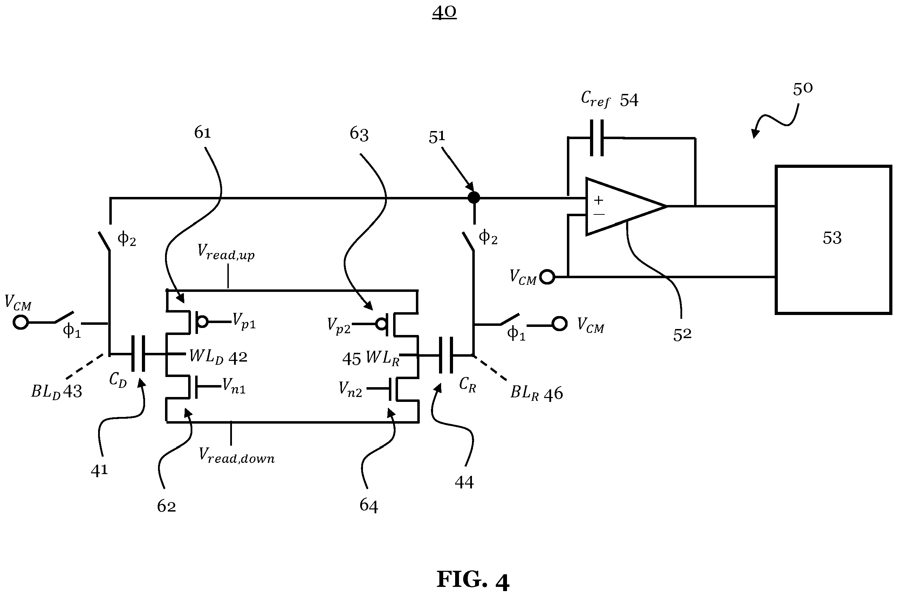

FIG. 3 shows a principle used in this disclosure for addressing the first problem of the small signal during a non-destructive read-out of a ferroelectric memory cell of a memory device, and for addressing the second problem that the signal may be obfuscated by larger signals (amplifier saturation etc...). The second problem can be solved by only transferring a difference in signal (II), while the first problem can be solved by summing over N ≥ 1 cycles to amplify the signal (I). Details can be derived from the following description of the solutions of this disclosure, which are described with reference to the FIGs. 4-7. It should be noted, however, that the described details are all exemplary and the solutions are described in the claims.

FIG. 4 shows a memory device 40 according to this disclosure. The memory device 40 may be a ferroelectric random access memory (FeRAM) device. The memory device 40 comprises at least one memory cell 41, but typically comprises an array of similar memory cells 41. The memory device 40 may be a 3D ferroelectric memory device, in which the array of memory cells 41 not only comprises rows and columns - as in a 2D memory device - but in which the memory cells 41 are also stacked along the third dimension. Each memory cell 41 of the memory device 40 is configured to store information based on a polarization state of a ferroelectric material.

The memory device 40 of FIG. 4 comprises at least the shown memory cell 41, which comprises a ferroelectric capacitor (denoted C_{D}) to store information. The memory cell 41 is connected to a word line 42 (denoted WL_{D}) and to a bit line 43 (denoted BL_{D}). In particular, if the memory device 40 is designed according to the 0T-1C configuration, the word line 42 is connected to a first capacitor plate of the ferroelectric capacitor C_{D} of the memory cell 41, and the bit line 43 is connected to a second capacitor plate of the ferroelectric capacitor C_{D} of the memory cell 41.

The first and the second capacitor plate may respectively be made of a metal or metal combination with a different work function. The first and second capacitor plates may respectively comprise one or more of: molybdenum; a composition comprising molybdenum and a molybdenum oxide; titanium nitride; a composition comprising ruthenium and titanium nitride; and tungsten. The first and second capacitor plate can either or both be selected from these materials or material combinations, wherein the first capacitor plate and the second capacitor plate may comprise different materials or material combinations, or the same. A ferroelectric material like hafnium-zirconium oxide (HZO), for example, lanthanum doped HZO (La:HZO), may be arranged between the two capacitor plates. The ferroelectric material is electrically excitable to two polarization states (e.g., "up" and "down"), each polarization state representing a memory state (e.g. "1" and "0") of the memory cell 41.

The memory device 40 could notably also be designed according to the 1T-1C configuration. In his case the memory cell 41 would additionally include a select transistor, and one terminal of the select transistor would be connected to one of the capacitor plates, instead of the word line 42.

The memory device 40 further comprises at least the shown reference cell 44, which comprises a ferroelectric capacitor (denoted C_{R}), which may be similar to the ferroelectric capacitor C_{D} of the memory cell 41 and may comprise the same materials. The reference cell 44 is connected to a reference word line 45 (denoted WL_{R}) and a reference bit line 46 (denoted BL_{R}). In particular, similar as for the memory cell 441, the reference word line 45 may be connected to a first capacitor plate of the ferroelectric capacitor C_{R} of the reference cell 44, and the reference bit line 46 may be connected to a second capacitor plate of the ferroelectric capacitor C_{R} of the reference cell 44.

The memory device also comprises a readout circuit 50, which can be used to read out the memory state of the memory cell 41 via the bit line 43. The readout circuit 50 comprises a summing node 51, and a differential amplifier 52 connected to the summing node 51. The exemplarily shown differential amplifier 52 receives a summing result of the summing node 51 as a non-inverting input, and receives the reference voltage as an inverting input. The readout circuit 50 further comprises a comparator 53, which is configured to receive an output of the differential amplifier 52 as one input, and to receive the reference voltage as another input. The readout circuit 50 finally comprises an accumulation capacitor 54 (denoted C_{ref}), which is connected in parallel to the differential amplifier 52 between the summing node 51 and the comparator 53.

The memory device 40 also comprises a set of first switches Φ1 and a second set of switches Φ2. When the first switches Φ1 are closed, the bit line 43 and the reference bit line 46 are connected to a reference voltage (denoted V_{CM}). For example, a first switch Φ1 may be arranged to connect the bit line 43 to a reference voltage node, and another first switch Φ1 may be arranged to connect the reference bit line 46 to the same or a different reference voltage node. When the second switches Φ2 are closed, the bit line 43 and the reference bit line 46 are each connected to the summing node 51. For example, a second switch Φ2 may be arranged to connect the bit line 42 to the summing node 51, and another second switch Φ2 may be arranged to connect the reference bit line 46 to the summing node 51.

To switch the word line 42 and the reference word line 45, respectively, the memory device 40 may optionally (as illustrated) comprise a pair of a first pull-up transistor 61 and a first pull-down transistor 62 connected to the word line 42, and a pair of a second pull-up transistor 63 and a second pull-down transistor 64 connected to the reference word line 46. The first pair is configured to pull the word line 42 selectively to a first read voltage (denoted V_{read,up}) and to a second read voltage (denoted V_{read,down}). The first read voltage is higher than the second read voltage, and the reference voltage is between the first and the second read voltage, for instance, is exactly the mid-point between the two read voltages. The second pair is configured to pull the reference word line 46 selectively to the first read voltage and the second read voltage. The pull-up transistors 61, 63 may be PMOS transistors, e.g. p-FETs, and the pull-down transistors 62, 64 may be NMOS transistors, e.g. n-FETs.

The first pull-up transistor 61 is connected with one of its terminals to the first read voltage, and with its other terminal to the word line 42 and to a terminal of the first pull-down transistor 62. The first pull-down transistor 62 is connected with one of its terminals to the second read voltage, and with its other terminal to the word line 42 and to the terminal of the first pull-up transistor 61. The second pull-up transistor 63 is connected with one of its terminals to the first read voltage, and with its other terminal to the reference word line 45 and to a terminal of the second pull-down transistor 64. The second pull-down transistor 64 is connected with one of its terminals to the second read voltage, and with its other terminal to the reference word line 45 and to the terminal of the second pull-up transistor 63.

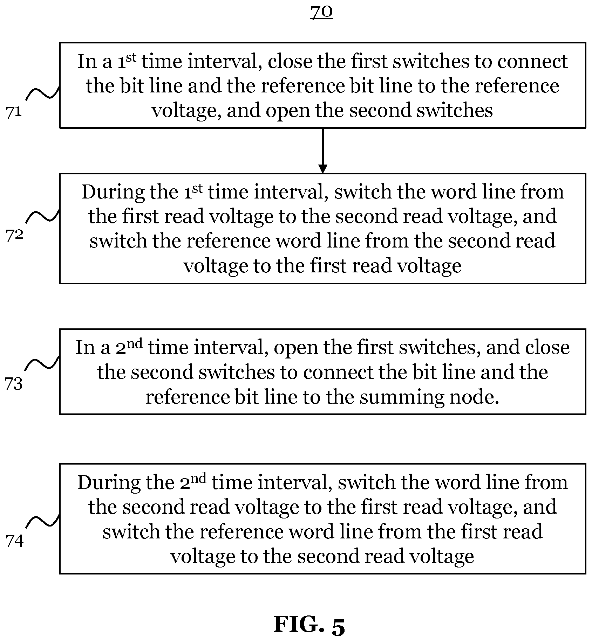

FIG. 5 shows a flow-diagram of a method 70 for operating the memory device 40. In particular, the method 70 is for performing a non-destructive read-out of the memory cell 41, and to this end the first switches Φ1 and the second switches Φ2 are switched in at least two consecutive time intervals. In a first time interval, the first switches Φ1 are all closed (conducting), which connects the bit line 43 and the reference bit line 46, respectively, to the reference voltage, while the second switches Φ2 are all open (non-conducting). In a second time interval, the first switches Φ1 are open and the second switches Φ2 are closed, which connects the bit line 43 and the reference bit line 46, respectively, to the summing node 51. During the first time interval, the word line 42 is switched from the first read voltage to the second read voltage, and the reference word line 45 is switched from the second read voltage to the first read voltage. During the second time interval, the word line 42 is switched from the second read voltage to the first read voltage, and the reference word line 45 is switched from the first read voltage to the second read voltage.

The switching of the word line 42 and the reference word line 46 during the two time intervals can be implemented by switching control signals of the two pull-up transistors 61, 63 and the pull-down transistors 62, 64 . Thereby, the control signals (which are applied to the respective transistor gate) of the first pull-up transistor 61 and the first pull-down transistor 62 are switched opposite in phase compared to respectively the control signals of the second pull-up transistor 63 and the second pull-down transistor 64.

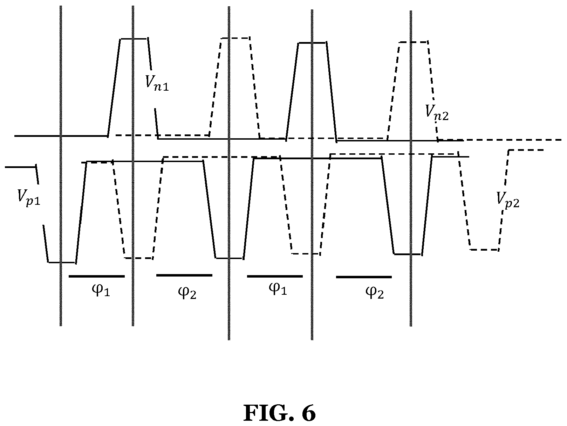

An exemplary timing diagram for the switching of the control signals is shown in FIG. 6. In FIG. 6, Vₚ₁ denotes the control signal of the first pull-up transistor 61, Vₙ₁ denotes the control signal of the first pull-down transistor 62, Vₚ₂ denotes the control signal of the second pull-up transistor 63, and Vₙ₂ denotes the control signal of the second pull-down transistor 64 (the four control signals of the four transistors 61-64 are also indicated in FIG. 4). The switching sequence of the control signals Vₚ₁ and Vₙ₁, in order to switch the word line 42 during the two time intervals - where φ1 in FIG. 6 means that the first switches Φ1 are closed (first time interval) and φ2 means that the second switches Φ2 are closed (second time interval) - may be as follows.

Initially, in the first time interval φ1, both Vₚ₁ and Vₙ₁ start low. The first pull-up transistor 61 is thus on (because in this case it is a PMOS transistor), and the second pull-up transistor 62 is off (because in this case it is an NMOS transistor).

The word line 42 is consequently pulled to the first read voltage. Then, still in the first time interval φ1, Vₚ₁ goes high, turning off the first pull-up transistor 61. Shortly thereafter, Vₙ₁ goes high, thus turning on the first pull-down transistor 62 and pulling the word line to the second read voltage. Then Vₙ₁ goes low again, in the second time interval φ2, thus turning the first pull-down transistor 62 off again. With Vₚ₁ still remaining high and Vₙ₁ now low, both the first pull-up transistor 61 and the first pull-down transistor 62 are off, wherein the word line 42 is held at the second read voltage. Thereafter, Vₚ₁ transitions back to low, turning the first pull-up transistor 61 on again and pulling the word line 42 back up to the first read voltage at the end of the second time interval φ2. The time intervals φ1 and φ2 can be repeated one or more times for alternatingly switching high and low the word line 42.

The switching of the control signals Vₚ₂ and Vₙ₂ for switching the reference word line 45 is similar, but opposite in phase. The switching of the first switches Φ1 and second switches Φ2 and the switching of the control signals Vₚ₁, Vₙ₁, Vₚ₂, and Vₙ₂ of the pull-up and pull-down transistors 61, 62, 63, 64 are preferably non-overlapping.

With reference again to FIG. 4, due to the alternation of the two intervals φ1 and φ2 shown in FIG. 6 (related to the first switches Φ1 and second switches Φ2), a charge is first sampled from (V_{read,up}-V_{read,down}) on the ferroelectric capacitor C_{D} of the memory cell 41 and the ferroelectric capacitor C_{R} of the reference cell 44 during the first time interval φ1, and then transferred to the accumulation capacitor C_{ref} during the second time interval φ2. The control signal pulses for controlling the word line 42 and reference word line 45 (Vₙ₁/Vₚ₁ for the word line 42 and Vₙ₂/Vₚ₂ for the reference word line 45) have opposite polarity during the first and second time interval, so that the reference bit line 46 charges the accumulation capacitor C_{Cref} by C_{R}(V_{read,up} - V_{read,down}) while the bit line 43 discharges it by C_{D}(V_{read,up} - V_{read,down}), hence creating a different signal at the output of the operational amplifier 52. The signal may be amplified, if multiple cycles of the first and second time interval are performed. The differential charge (C_{R} - C_{D})·ΔV is transferred each cycle and summed up, wherein ΔV= V_{read,up}-V_{read,down}. The read out signal is N·(C_{R}- C_{D})·ΔV/C_{ref} >> 100mV, wherein N is the number of cycles.

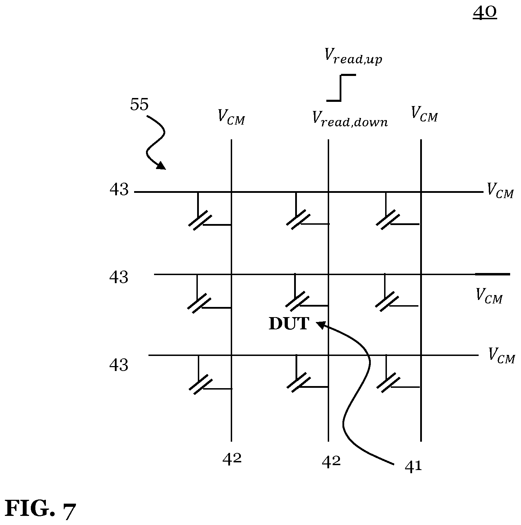

FIG. 7 shows a memory device 40 according to this disclosure, which bases on FIG. 4. In particular the memory device 40 of FIG. 7 includes a plurality of memory cells 41 including the memory cell 41 shown in FIG. 4 and described before. Each of the memory cells 41 comprises a ferroelectric capacitor. The memory cells 41 are arranged in an array 55 comprising rows and columns.

The array 55 may be a cross-bar arrangement as shown with a plurality of word lines 42 and a plurality of bit lines 43. Each of the word lines 42 is connected to the memory cells 41 of one row (here vertical), each of the bit lines 43 is connected to the memory cells 41 of one column (here horizontal), and each of the memory cells 41 is placed between one of the word lines 42 and one of the bit lines 43.

The memory device 40 further comprises a plurality of reference cells 44 (not shown), including the reference cell 44 shown in FIG. 4 and described before. Each of the reference cells 44 comprises a ferroelectric capacitor. Each reference cell 44 is placed between one of one or more reference word lines 45 and one of a plurality of reference bit lines 46.

The memory device 40 further comprises a plurality of readout circuits 50 (not shown in FIG. 7). Each of the readout circuits 50 comprises a summing node 51, a differential amplifier 52, a comparator 53, and an accumulation capacitor 54, like shown for the readout circuit 50 in FIG. 4. Each readout circuit 50 is associated with one pair of one of the bit lines 43 and one of the reference bit lines 46, and each readout circuit 50 can read out memory cells 41 connected to the bit line 43. Each read-out circuit 50 may be connected to its associated pair of one bit line 43 and one reference bit line 46 in the manner shown in FIG. 4.

In the claims as well as in the description of this disclosure, the word 'comprising' does not exclude other elements or steps and the indefinite article 'a' or 'an' does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. A memory device (40) comprising:
a memory cell (41) comprising a ferroelectric capacitor;
a word line (42) and a bit line (43), which are respectively connected to the memory cell (41);
a reference cell (44) comprising a ferroelectric capacitor;
a reference word line (45) and a reference bit line (46) respectively connected to the reference cell (44);
a set of first switches (Φ1) configured to connect, when the first switches (Φ1) are closed, the bit line (43) and the reference bit line (46) to a reference voltage;
a set of second switches (Φ2) configured to connect, when the second switches (Φ2) are closed, the bit line (43) and the reference bit line (46) to a summing node (51) of a readout circuit (50) of the memory device (40);
wherein the readout circuit (50) comprises:
the summing node (51);
a differential amplifier (52) configured to receive a summing result of the summing node (51) and the reference voltage as two inputs;
a comparator (53) configured to receive an output of the differential amplifier (52) and the reference voltage as two inputs; and
an accumulation capacitor (54) connected in parallel to the differential amplifier (52) between the summing node (51) and the comparator (53).

2. The memory device (40) according to claim 1, further comprising:
a first pull-up transistor (61) and a first pull-down transistor (62) connected to the word line (42) and respectively configured to pull the word line (42) to a first read voltage and a second read voltage, wherein the first read voltage is higher than the second read voltage and the reference voltage is between the first and the second read voltage;
a second pull-up transistor (63) and a second pull-down transistor (64) connected to the reference word line (46) and respectively configured to pull the reference word line (46) to the first read voltage and the second read voltage.

3. The memory device (40) according to claim 1 or 2, wherein the word line (42) is connected to a first capacitor plate of the ferroelectric capacitor of the memory cell (41), and the bit line (43) is connected to a second capacitor plate of the ferroelectric capacitor of the memory cell (41).

4. The memory device (40) according to one of the claims 1 to 3, wherein the reference word line (45) is connected to a first capacitor plate of the ferroelectric capacitor of the reference cell (44), and the reference bit line (46) is connected to a second capacitor plate of the ferroelectric capacitor of the reference cell (44).

5. The memory device (40) according to one of the claims 1 to 4, wherein the set of first switches (Φ1) comprises:
a first switch (Φ1) arranged on the bit line (43) between the ferroelectric capacitor of the memory cell (41) and the summing node (51); and
another first switch (Φ1) arranged on the reference bit line (46) between the ferroelectric capacitor of the reference cell (44) and the summing node (51).

6. The memory device (40) according to one of the claims 1 to 5, wherein the set of second switches (Φ2) comprises:
a second switch (Φ2) arranged on the bit line (43) between the ferroelectric capacitor of the memory cell (41) and a reference voltage node; and
another second switch (Φ2) arranged on the reference bit line (46) between the ferroelectric capacitor of the reference cell (44) and the reference voltage node.

7. The memory device (40) according to one of the claims 1 to 6, wherein the differential amplifier (52) is configured to receive the summing result of the summing node (51) as a non-inverting input and to receive the reference voltage as an inverting input.

8. The memory device (40) according to one of the claims 1 to 7, comprising:
a plurality of memory cells (41), wherein each of the memory cells (41) comprises a ferroelectric capacitor, and wherein the memory cells (41) are arranged in an array (55) comprising rows and columns;
a plurality of word lines (42) and a plurality of bit lines (43), wherein each of the word lines (42) is connected to the memory cells (41) of one row, each of the bit lines (43) is connected to the memory cells (41) of one column, and each of the memory cells (41) is placed between one of the word lines (42) and one of the bit lines (43);
a plurality of reference cells (44), wherein each of the reference cells (44) comprises a ferroelectric capacitor;
one or more reference word lines (45) and a plurality of reference bit lines (46), wherein each reference cell (44) is placed between one reference word line (43) and one of the reference bit lines (46); and
a plurality of readout circuits (50), wherein each of the readout circuits (50) comprises a summing node (51), a differential amplifier (52), a comparator (53) and an accumulation capacitor (54), and wherein each of the readout circuits (50) is associated with one pair of one of the bit lines (43) and one of the reference bit lines (46).

9. The memory device (40) according to claim 8, wherein all the reference cells (44) are arranged in an extra row of the array (55), and the memory device (40) comprises one reference word line (45) connected to all the reference cells (44) in the extra row.

10. The memory device (40) according to one of the claims 1 to 9, further comprising a memory controller, which is configured to operate the memory device (40) according to the method of one of the claims 11 to 15.

11. A method (70) of operating a memory device (40) according to one of the claims 1 to 10 to read out the memory cell (41) using the reference cell (44), wherein the method (70) comprises:
switching (71) the first switches (Φ1) and the second switches (Φ2), which are associated with the bit line (43) and the reference bit line (46) respectively connected to the memory cell (41) and the reference cell (44), in consecutive time intervals; wherein
in a first time interval, the first switches (Φ1) are closed to connect the bit line (43) and the reference bit line (46) to the reference voltage, and the second switches (Φ2) are open;
in a second time interval, the first switches (Φ1) are open, and the second switches (Φ2) are closed to connect the bit line (43) and the reference bit line (46) to the summing node (51);
during the first time interval, the word line (42) is switched from the first read voltage to the second read voltage, and the reference word line (45) is switched from the second read voltage to the first read voltage; and
during the second time interval, the word line (42) is switched from the second read voltage to the first read voltage, and the reference word line (45) is switched from the first read voltage to the second read voltage.

12. The method (70) according to claim 11 for operating a memory device (40) according to one of the claims 2 to 10, wherein the method (70) further comprises:
switching control signals of respectively the first pull-up transistor (61), the first pull-down transistor (62), the second pull-up transistor (63), and the second pull-down transistor (64), in the consecutive time intervals, in order to respectively switch the word line (42) and the reference word line (45) between the first and the second read voltage.

13. The method (70) according to claim 12, wherein the control signals of the first pull-up transistor (61) and the first pull-down transistor (62) are switched opposite in phase compared to the control signals of respectively the second pull-up transistor (63) and the second pull-down transistor (64).

14. The method (70) according to claim 12 or 13, wherein the switching of the first switches (Φ1) and second switches (Φ2) and the switching of the control signals of the first and second pull-up and pull-down transistors (61, 62, 63, 64) are non-overlapping.

15. The method (70) of one of the claims 11 to 14, wherein the method (70) comprises multiple cycles to read out the memory cell (41) using the reference cell (44), wherein each cycle comprises the first and the second time interval.
